# EUROPÄISCHE PATENTSCHRIFT

(11) **EP 3 282 269 B1**
(45) Veröffentlichungstag und Bekanntmachung des Hinweises auf die Patenterteilung: **12.09.2018**
(21) Anmeldenummer: 17185260.1
(22) Anmeldetag: 08.08.2017
(51) Int. Cl.: G01R 33/30, G01R 33/31, G01R 33/3815, H01F 6/04

(54) **NMR-APPARATUR MIT DURCH EINE VAKUUMSCHLEUSE IN DEN KRYOSTATEN EINER SUPRALEITENDEN MAGNETANORDNUNG EINFÜHRBAREN GEKÜHLTEN PROBENKOPFKOMPONENTEN SOWIE VERFAHREN ZU DEREN EIN- UND AUSBAU**
NMR APPARATUS WITH COOLED SAMPLE HEAD COMPONENTS WHICH CAN BE INSERTED THROUGH A VACUUM LOCK INTO THE CRYOSTAT OF A SUPERCONDUCTING MAGNET ARRANGEMENT AND METHOD FOR ITS ASSEMBLY AND DISASSEMBLY
APPAREIL RMN POURVU DES COMPOSANTS FORMANT SONDES, REFROIDIS PAR L'INTERMÉDIAIRE D'UN SAS SOUS VIDE DANS UN CRYOSTAT D'UN ASSEMBLAGE D'AIMANTS SUPRACONDUCTEURS AINSI QUE PROCÉDÉ DE MONTAGE ET SON DÉMONTAGE

(30) Priorität: 09.08.2016 DE 102016214728
(43) Veröffentlichungstag der Anmeldung: 14.02.2018
(73) Patentinhaber: Bruker BioSpin AG, 8117 Fällanden (CH)
(72) Erfinder: Schauwecker, Robert, 8004 Zürich (CH); Hinderer, Jörg, 79761 Waldshut-Tiengen (DE)
(74) Vertreter: Kohler Schmid Möbus Patentanwälte

(56) Entgegenhaltungen:
- EP-A2- 1 435 525
- DE-B3-102013 201 110
- GB-A- 2 489 566
- JP-A- H07 120 543
- US-A1- 2012 242 335
- US-A1- 2012 319 690

## Beschreibung

Die Erfindung betrifft eine NMR-Apparatur mit einer supraleitenden Magnetanordnung mit einem Kryostaten, welcher einen Vakuumbehälter und eine auf einer Betriebstemperatur < 100 K betreibbare Kältestufe umfasst, und mit einem supraleitenden Magnetspulensystem mit einer Kaltbohrung, in die ein Raumtemperaturzugang des Kryostaten eingreift, wobei die NMR-Apparatur einen NMR-Probenkopf mit auf eine Betriebstemperatur < 100 K zu kühlenden Probenkopfkomponenten umfasst. Eine solche Anordnung ist etwa bekannt aus US 2012/0319690 A1.

Außerdem betrifft die Erfindung ein Verfahren zum Ein- und Ausbau der zu kühlenden Probenkopfkomponenten in den Vakuumbehälter eines Kryostaten einer supraleitenden Magnetanordnung einer NMR-Apparatur.

### Hintergrund der Erfindung

Das Einsatzgebiet der vorliegenden Erfindung bildet ein kryogenes System zur Kühlung eines supraleitenden Magnetspulensystems sowie zur Kühlung von Komponenten eines NMR-Probenkopfs beispielsweise für Anwendungen der Magnetresonanzspektroskopie (=NMR) oder der Magnetresonanztomographie (=MRI). Die Anwendbarkeit der Erfindung ist jedoch nicht auf dieses Gebiet beschränkt.

Supraleitende Magnetspulensysteme werden in einem Kryostaten betrieben, um die Temperatur unterhalb der Sprungtemperatur des Supraleiters zu halten. Typischerweise umfasst der Kryostat einen Vakuumbehälter, worin ein oder mehrere Kryobehälter mit je einem Kühlfluid, beispielsweise Flüssighelium oder Flüssigstickstoff, angeordnet sind. Das supraleitende Magnetspulensystem ist im kältesten Kryobehälter eingebaut. Damit ergibt sich eine sehr temperaturstabile und gleichmäßige Kühlung des supraleitenden Magnetspulensystems. Solche badgekühlten Systeme sind üblich für beispielsweise NMR Spektrometer. Bei diesen Systemen müssen die Kühlfluide in regelmäßigen Zeitintervallen nachgefüllt werden, da der Wärmeeintrag auf die Kryobehälter für ein stetiges Verdampfen der Kühlfluide sorgt. Alternativ dazu können die Kühlfluide durch einen Kryokühler am Kryostaten rückverflüssigt werden, oder die Kühlung erfolgt durch thermische Anbindung des supraleitenden Magnetspulensystems und/oder eines oder mehrerer Strahlungsschilde des Kryostaten an eine Kühlstufe eines Kryokühlers.

Zum Einbau eines NMR-Probenkopfs verfügt der Vakuumbehälter des Kryostaten typischerweise über einen Raumtemperaturzugang in die Kaltbohrung des supraleitenden Magnetspulensystems. Weil sich der Betrieb des NMR-Probenkopfs auf Raumtemperatur nachteilig auf die Signalqualität auswirkt, werden Probenköpfe mit gekühlten Komponenten eingesetzt. Es sind verschiedene Ausführungsformen solcher Kryoprobenköpfe bekannt.

Üblicherweise werden Kryoprobenköpfe demontierbar im Raumtemperaturzugang des Kryostaten angebracht, wobei die gekühlten Komponenten dann in einem eigenen Isolationsbehälter angeordnet sind und über einen Kühlkreislauf gekühlt werden. Es sind aber auch Kryoprobenköpfe bekannt, welche mindestens teilweise fest im Isolationsvakuum des Kryostaten montiert sind.

### Stand der Technik

Verschiedene kryogene Systeme zur Kühlung eines supraleitenden Magnetspulensystems und zur Kühlung von Komponenten eines NMR-Probenkopfs sind bekannt, welche sich insbesondere hinsichtlich der mechanischen Integration von Magnetanordnung und Probenkopf zu einer apparativen Einheit und hinsichtlich der gemeinsamen Nutzung von Komponenten des kryogenen Systems zur Kühlung des Magnetspulensystems und des Probenkopfs unterscheiden.

In US 2012/0242335 A1, US 2007/0107445 A1, US 2005/0202976 A1, US 2006/0130493 A1 und US 2013/063148 A1 sind Anordnungen offenbart mit einem im Raumtemperaturzugang des Kryostaten der Magnetanordnung demontierbar angebrachten Kryoprobenkopf.

In US 2012/0242335 A1 wird der Kryoprobenkopf über einen Kühlkreislauf gekühlt, welcher thermisch an ein Kältereservoir des Kryostaten der Magnetanordnung angebunden ist, beispielsweise an einen Flüssigstickstoff-Behälter.

In US 2007/0107445 A1, US 2005/0202976 A1, US 2006/0130493 A1 und US 2013/063148 A1 werden der Kryoprobenkopf und Teile des Kryostaten der Magnetanordnung über einen gemeinsamen Kryokühler gekühlt.

Die Nachteile dieser Anordnungen sind ein hoher apparativer Aufwand für den Kühlkreislauf des Probenkopfs und Kühlleistungsverluste aufgrund der apparativen Komplexität des Kühlkreislaufs. Ausserdem müssen die gekühlten Probenkopfkomponenten in einem eigenen Isolationsvakuum angeordnet werden, was sich aufgrund des erhöhten Platzbedarfs des Kryoprobenkopfs im Raumtemperaturzugang des Kryostaten der Magnetanordnung nachteilig auf die Kompaktheit des supraleitenden Magnetspulensystems auswirkt.

Eine Anordnung gemäß US 2012/0319690 A1 weist einen im Vakuumbehälter des Kryostaten der supraleitenden Magnetanordnung eingebauten Kryoprobenkopf auf. Nachteilig bei dieser Anordnung ist jedoch der Verlust der mechanischen Modularität von Magnetanordnung und Kryoprobenkopf. Um den Kryoprobenkopf auszuwechseln, beispielsweise bei einem Defekt oder für die Durchführung von NMR-Messungen mit unterschiedlichen Anforderungen an den Funktionsumfang des Kryoprobenkopfs, muss das Kryostatvakuum gebrochen werden. Der Probenkopfwechsel bedingt also ein Entladen des supraleitenden Magnetspulensystems und ein Aufwärmen der Magnetanordnung.

### Aufgabe der Erfindung

Der vorliegenden Erfindung liegt demgegenüber die Aufgabe zugrunde, eine NMR-Apparatur der eingangs beschriebenen Art mit einem supraleitenden Magnetspulensystem in einem Kryostaten und mit einem Kryoprobenkopf, dessen gekühlte Komponenten im Betriebszustand innerhalb des Vakuumbehälters des Kryostaten angeordnet sind, mit möglichst einfachen technischen Mitteln dahingehend zu verbessern, dass die gekühlten Probenkopfkomponenten in den Vakuumbehälter hinein- und aus diesem herausbewegt werden können, ohne dass das Isolationsvakuum im Vakuumbehälter des Kryostaten gebrochen werden muss.

### Kurze Beschreibung der Erfindung

Diese Aufgabe wird erfindungsgemäß auf ebenso überraschend einfache wie wirkungsvolle Weise sowie mit ohne Weiteres zur Verfügung stehenden technischen Mitteln dadurch gelöst, dass die zu kühlenden Probenkopfkomponenten mindestens zum Teil in einem Bereich zwischen der Kaltbohrung des supraleitenden Magnetspulensystems und dem Raumtemperaturzugang des Kryostaten in die Kaltbohrung radial innerhalb der Kaltbohrung, aber außerhalb des Raumtemperaturzugangs des Kryostaten angeordnet sind, dass ein Schleusenventil vorgesehen ist, und dass der Vakuumbehälter des Kryostaten eine mit dem einem Schleusenventil verschließbare Öffnung sowie eine Schleusenkammer im unmittelbaren Anschluss an die Öffnung oder eine Vorrichtung zur vakuumdichten Anbringung einer Schleusenkammer im unmittelbaren Anschluss an die Öffnung aufweist, und dass die Öffnung und das Schleusenventil so dimensioniert und derart angeordnet sind, dass die zu kühlenden Probenkopfkomponenten durch sie hindurch ein- und/oder ausgebaut werden können.

### Wirkungsweise der Erfindung und weitere Vorteile gegenüber dem Stand der Technik

Die vorliegende Erfindung schlägt also eine NMR-Apparatur vor, welche es ermöglicht, die gekühlten Komponenten eines Kryoprobenkopfs durch einen Schleusenmechanismus in den Vakuumbehälter des Kryostaten einer supraleitenden Magnetanordnung unter Vakuum ein- und auszubauen, so dass die Magnetanordnung für diesen Vorgang nicht aufgewärmt werden muss oder sogar in geladenem Zustand verbleiben kann.

Diese Anordnung verbindet die Vorteile eines mindestens teilweise innerhalb des Vakuumbehälters des Kryostaten angeordneten Kryoprobenkopfs, nämlich die einfache und platzsparende Bauweise ohne eigenen Isolationsbehälter für die gekühlten Probenkopfkomponenten, mit den Vorteilen eines innerhalb des Raumtemperaturzugangs des Kryostaten angeordneten Kryoprobenkopfs, insbesondere dem einfachen Ein- und Ausbau des Kryoprobenkopfs im Falle eines Defekts oder bei Benutzung von unterschiedlichen Typen von Kryoprobenköpfen für verschiedene NMR-Anwendungen. Die Möglichkeit zur Anbringung von weiteren Funktionseinheiten des Probenkopfs im Raumtemperaturzugang, beispielsweise eines NMR-Messproben-Rotors, besteht weiterhin.

### Bevorzugte Ausführungsformen der Erfindung

Besonders bevorzugt sind Ausführungsformen der Erfindung, bei denen die in einem Bereich zwischen der Kaltbohrung des supraleitenden Magnetspulensystems und dem Raumtemperaturzugang des Kryostaten in der Kaltbohrung angeordneten zu kühlenden Probenkopfkomponenten eine HF-Spule umfassen. Der platzsparende Einbau gekühlter HF-Spulen im Vakuumbehälter des Kryostaten ohne eigenen Isolationsbehälter wirkt sich besonders vorteilhaft auf die kompakte Bauweise des supraleitenden Magnetspulensystems aus, weil die HF-Spulen direkt um die NMR-Messprobe innerhalb des Arbeitsvolumens der Magnetanordnung angeordnet sind.

Ganz besonders bevorzugt ist eine Klasse von Ausführungsformen der erfindungsgemäßen NMR-Apparatur, bei denen ein mechanisch lösbarer thermischer Kontakt zwischen den zu kühlenden Probenkopfkomponenten und einer Kältestufe des Kryostaten vorhanden ist. Bei Kühlung über thermische Anbindung an eine Kältestufe des Kryostaten braucht es keine separate Kühlvorrichtung für den Kryoprobenkopf, was eine besonders kostengünstige und thermisch effiziente Lösung darstellt.

Vorteilhafte Weiterbildungen dieser Klasse von Ausführungsformen sind dadurch gekennzeichnet, dass der Kryostat eine Kältestufe mit einem Stickstoffbehälter umfasst, und dass die zu kühlenden Probenkopfkomponenten über einen lösbaren thermischen Kontakt an die den Stickstoffbehälter umfassende Kältestufe des Kryostaten gekoppelt sind.. Diese Weiterbildungen nutzen die hohe Kühlleistung durch die Verdampfung von Flüssigstickstoff und die thermische Stabilität des Flüssigsticksoff-Bades und erweisen sich als besonders kostengünstige Lösung.

Dazu alternative Weiterbildungen von Ausführungsformen der erfindungsgemäßen NMR-Apparatur sind dadurch gekennzeichnet, dass der Kryostat eine Kältestufe mit einem durch einen einstufigen Kryokühler gekühlten Strahlungsschild umfasst, und dass die zu kühlenden Probenkopfkomponenten über einen lösbaren thermischen Kontakt an die den durch einen einstufigen Kryokühler gekühlten Strahlungsschild umfassende Kältestufe des Kryostaten gekoppelt sind. Ein Kryostat einer supraleitenden Magnetanordnung mit einem derart gekühlten Strahlungsschild hat als Alternative zu einem Stickstoffbehälter in einem Kryostaten den Vorteil, dass die Betriebstemperatur des Strahlungsschildes tiefer ist als jene eines durch Stickstoffverdampfung gekühlten Behälters, womit auch die gekühlten Probenkopfkomponenten auf einer tieferen Temperatur betrieben werden können. Außerdem entfällt die Notwendigkeit von periodischen Stickstofffüllungen.

Dazu alternative Weiterbildungen von Ausführungsformen der erfindungsgemäßen NMR-Apparatur sind dadurch gekennzeichnet, dass der Kryostat eine Kältestufe mit einem durch die erste Stufe eines zweistufigen Kryokühlers gekühlten Strahlungsschild umfasst, und dass die zu kühlenden Probenkopfkomponenten über einen lösbaren thermischen Kontakt an die den durch die erste Stufe eines zweistufigen Kryokühlers gekühlten Strahlungsschild umfassende Kältestufe des Kryostaten gekoppelt sind. Ein Kryostat einer supraleitenden Magnetanordnung mit einem derart gekühlten Strahlungsschild hat als Alternative zu einem durch einen einstufigen Kryokühler gekühlten Strahlungsschild den Vorteil, dass ein supraleitendes Magnetspulensystem insbesondere mit Tieftemperatursupraleitern durch thermische Anbindung an die zweite (kältere) Stufe des Kryokühlers gekühlt werden kann, oder dass an der zweiten Stufe des Kryokühlers Heliumgas aus einem Heliumbehälter des Kryostaten verflüssigt werden kann.

Dazu alternative Weiterbildungen von Ausführungsformen der erfindungsgemäßen NMR-Apparatur sind dadurch gekennzeichnet, dass der Kryostat eine Kältestufe mit einem durch einen einstufigen Kryokühler gekühlten supraleitenden Magnetspulensystem umfasst, und dass die zu kühlenden Probenkopfkomponenten über einen lösbaren thermischen Kontakt an die das durch einen einstufigen Kryokühler gekühlte supraleitende Magnetspulensystem umfassende Kältestufe des Kryostaten gekoppelt sind. Diese Weiterbildungen sind insbesondere für kroygenfrei betriebene supraleitende Magnetanordnungen mit einem supraleitenden Magnetspulensystem aus Hochtemperatursupraleiter vorteilhaft. Ein solches Magnetspulensystem kann durch thermische Anbindung an einen einstufigen Kryokühler auf für einen effizienten Betrieb ausreichend tiefe Temperaturen gekühlt werden.

Eine vorteilhafte Weiterbildung dieser Klasse von Ausführungsformen ist dadurch gekennzeichnet, dass der mechanisch lösbare thermische Kontakt thermische Kontaktelemente umfasst, die auf den beiden Seiten des mechanisch lösbaren thermischen Kontaktes als Konus und als dazu formschlüssiger Gegenkonus ausgebildet sind, wobei Konus und Gegenkonus aus einem wärmeleitenden Material mit einer Wärmeleitfähigkeit bei der Betriebstemperatur der Anordnung von mehr als 20 W / (K * m), insbesondere aus Kupfer, gefertigt sind, wobei Konus und Gegenkonus mit einem Edelmetall, insbesondere mit Gold, beschichtet sind, und wobei im Betriebszustand Konus und Gegenkonus durch ein Federelement mit einer Kraft von mindestens 20 N gegen einander gedrückt werden. Dadurch wird ein optimaler Wärmeübertrag zwischen den gekühlten Probenkopfkomponenten und einer Kältestufe des Kryostaten hergestellt.

Vorteilhaft ist auch eine Klasse von Ausführungsformen der erfindungsgemäßen NMR-Apparatur, bei denen die zu kühlenden Probenkopfkomponenten über einen externen Kühlkreislauf von außerhalb des Kryostaten kühlbar sind. Dies führt zu einer erheblichen mechanischen Vereinfachung, weil keine thermische Anbindung der gekühlten Probenkopfkomponenten an eine Kältestufe des Kryostaten nötig ist. Außerdem ergibt sich keine Störung des thermischen Gleichgewichts der Kältestufen des Kryostaten, insbesondere jener des supraleitenden Magnetspulensystems, aufgrund wechselnder thermischer Lasten von den gekühlten Probenkopfkomponenten. Die benötigte Kühlleistung kann unabhängig vom Kühlkonzept des Kryostaten an den Wärmeeintrag des Probenkopfs angepasst werden. Besonders vorteilhaft ist diese Ausführungsform bei hoher Wärmeleistung des Probenkopfs.

Die zu kühlenden Probenkopfkomponenten der erfindungsgemäßen NMR-Apparatur können normalleitende und/oder supraleitende Bauteile umfassen. Normalleitende Bauteile sind kostengünstiger und stellen geringere Anforderungen an die Kühlung. Demgegenüber ergeben supraleitende Bauteile eine bessere Signalqualität.

Besonders bevorzugt ist auch eine Ausführungsform der Erfindung, bei der ein mechanisch lösbarer thermischer Kontakt zwischen den gekühlten Probenkopfkomponenten und einer Kältestufe des Kryostaten vorhanden ist, und bei der die gekühlten Probenkopfkomponenten über einen externen Kühlkreislauf von außerhalb des Kryostaten kühlbar sind, wobei das probenkopfseitige thermische Kontaktelement im Betriebszustand der Anordnung kälter ist als das thermische Kontaktelement der Kältestufe des Kryostaten. Diese Anordnung erlaubt es, die Kühlleistung eines Kühlkreislaufs mit einem leistungsstarken, außerhalb des Kryostaten angeordneten Kryokühlers nicht nur zur Kühlung von Probenkopfkomponenten zu nutzen, sondern zusätzlich Wärme von einer Kältestufe des Kryostaten, beispielsweise einem um einen Kryobehälter angeordneten Strahlungsschild, aufzunehmen. Dadurch kann beispielsweise die Verdampfungsrate von kryogenen Flüssigkeiten aus einem Kryobehälter der Kryostatanordnung gesenkt werden.

Ganz besonders bevorzugt sind auch Ausführungsformen der erfindungsgemäßen NMR-Apparatur, bei welchen der NMR-Probenkopf so gestaltet ist, dass ein Teil des NMR-Probenkopfs das geöffnete Schleusenventil in der Öffnung im Vakuumbehälter luftdicht abschliesst, so dass der Schleusenbehälter im Betriebszustand demontierbar ist. Spezifische Vorteile dieser Ausführungsformen sind ein verbesserter Schutz gegen Vakuumbruch sowie Zugänglichkeit des warmen Endes des eingebauten NMR-Probenkopfs zur Kontaktierung von elektrischen Anschlüssen oder Kühlleitungen.

Weitere vorteilhafte Ausführungsformen der Erfindung umfassen in der Schleusenkammer einen Lift-Mechanismus zum Ein- und Ausfahren der gekühlten Probenkopfkomponenten in den Vakuumbehälter. Dies ermöglicht ein kontrolliertes und präzises Ein- und Ausfahren des Probenkopfs.

Vorteilhaft sind auch Ausführungsformen mit Tieftemperatursupraleitern (LTS) oder Hochtemperatursupraleitern (HTS). Zur Kühlung von Magnetspulensystemen mit LTS auf die erforderlichen tiefen Betriebstemperaturen von wenigen Kelvin sind Kryostatanordnungen mit mehreren kaskadierten Kältestufen nötig, was besonders vielfältige Möglichkeiten zur thermischen Anbindung von gekühlten Probenkopfkomponenten bietet. Magnetspulensysteme mit HTS können auf ähnlichen Temperaturen betrieben werden wie gekühlte Probenkopfkomponenten, was eine thermische und mechanische Integration dieser beiden Bestandteile einer NMR-Apparatur besonders vorteilhaft macht.

Schließlich ist es auch von erheblichem Vorteil, wenn die Magnetanordnung eine aktive Shimvorrichtung mit Shimspulen oder eine passive Shimvorrichtung mit einem oder mehreren ferromagnetischen Feldformelementen innerhalb des Kryostaten zur Homogenisierung des erzeugten Magnetfelds umfasst, wobei die Shimvorrichtung zwischen der Kaltbohrung des supraleitenden Magnetspulensystems und den zu kühlenden Probenkopfkomponenten mit thermischer Anbindung an eine Kältestufe des Kryostaten oder an einen externen Kühlkreislauf angeordnet ist. Die Anordnung der Shimvorrichtung an diesem Ort ergibt eine hohe Shim-Effizient (innerhalb der Kaltbohrung des supraleitenden Magnetspulensystems, also nahe an der NMR-Messprobe), aber die Effizienz der HF-Spulen wird nicht beeinträchtigt (Anordnung radial außerhalb der gekühlten Probenkopfkomponenten). Die Kühlung der Shimvorrichtung verhindert unerwünscht große thermische Gradienten zwischen supraleitendem Magnetspulensystem, Shimvorrichtung und gekühlten Probenkopfkomponenten.

In den Rahmen der vorliegenden Erfindung fällt auch ein Verfahren zum Aus- und Einbau der zu kühlenden Probenkopfkomponenten in den Vakuumbehälter eines Kryostaten einer supraleitenden Magnetanordnung einer erfindungsgemäßen NMR-Apparatur, gekennzeichnet durch folgende Schritte:
1. Abkoppelung von Anschlussleitungen des NMR-Probenkopfs von anderen Teilen der NMR-Apparatur
2. Anbringung einer Schleusenkammer am Schleusenventil
3. Evakuation der Schleusenkammer
4. Verschiebung der auszubauenden Probenkopfkomponenten aus dem Vakuumbehälter des Kryostaten in die Schleusenkammer
5. Schließen des Schleusenventils
6. Fluten und Öffnen der Schleusenkammer, Entnahme der ausgebauten Probenkopfkomponenten
7. Einführen der einzubauenden Probenkopfkomponenten in die Schleusenkammer, Verschliessen und Evakuieren der Schleusenkammer
8. Öffnen des Schleusenventils
9. Verschiebung der einzubauenden Probenkopfkomponenten aus der Schleusenkammer in den Vakuumbehälter des Kryostaten
10. Fluten und Entfernen der Schleusenkammer
11. Ankoppelung der Anschlüsse eines externen Kühlkreislaufs an den NMR-Probenkopf

Die Vorteile dieses Verfahrens ist, dass die gekühlten Probenkopfkomponenten gewechselt werden können, ohne dass das Kryostatvakuum gebrochen und die Magnetanordnung aufgewärmt werden müsste.

### Detaillierte Beschreibung der Erfindung und Zeichnung

Die Erfindung ist in den Zeichnungen dargestellt und wird anhand von Ausführungsbeispielen näher erläutert. Es zeigen:
- Fig. 1: eine schematische Darstellung einer ersten Ausführungsform der erfindungsgemäßen NMR-Apparatur im Betriebszustand mit demontierter Schleusenkammer;
- Fig. 2: die Ausführungsform von Fig. 1 mit über ein Schleusenventil 109 angekoppelter Schleusenkammer 112;
- Fig. 3: eine schematische Darstellung einer zweiten Ausführungsform der erfindungsgemäßen NMR-Apparatur im Betriebszustand mit demontierter Schleusenkammer, bei der zusätzlich noch ein Heliumbehälter 105, ein Strahlungsschild 110 sowie ein Stickstoffbehälter 18 gezeigt sind;
- Fig. 4: eine schematische Darstellung einer dritten Ausführungsform der erfindungsgemäßen NMR-Apparatur im Betriebszustand mit demontierter Schleusenkammer, bei der zusätzlich noch ein Heliumbehälter 105, zwei Strahlungsschilde 21, 110 sowie ein einstufiger Kryokühler 301 gezeigt sind;
- Fig. 5: eine schematische Darstellung einer vierten Ausführungsform der erfindungsgemäßen NMR-Apparatur im Betriebszustand mit demontierter Schleusenkammer, bei der zusätzlich noch ein zweistufiger Kryokühler 309, ein Strahlungsschild 21, sowie ein Heliumbehälter 105 gezeigt sind;
- Fig. 6: eine schematische Darstellung einer fünften Ausführungsform der erfindungsgemäßen NMR-Apparatur im Betriebszustand mit demontierter Schleusenkammer, bei der zusätzlich noch ein zweistufiger Kryokühler 309, ein Strahlungsschild 21, sowie ein kryogenfreier Magnet 111 gezeigt sind;
- Fig. 7: eine schematische Darstellung einer sechsten Ausführungsform der erfindungsgemäßen NMR-Apparatur im Betriebszustand mit demontierter Schleusenkammer, bei der zusätzlich noch ein einstufiger Kryokühler 301, ein Strahlungsschild 21, sowie ein kryogenfreies, auf Hochtemperatursupraleitern basierendes supraleitendes Magnetspulensystem 111 gezeigt sind;
- Fig. 8: eine schematische Darstellung einer siebten Ausführungsform der erfindungsgemäßen NMR-Apparatur im Betriebszustand mit demontierter Schleusenkammer, bei der zusätzlich noch ein Heliumbehälter 105, zwei Strahlungsschilde 21, 110 sowie ein einstufiger Kryokühler 301 gezeigt sind, und bei der die gekühlten Probenkopfkomponenten 9, 10 über thermische Kontaktelemente 302, 303 an die Strahlungsschilde 21, 110 gekoppelt sind;
- Fig. 9: eine schematische Darstellung der thermischen Kontaktelemente 302, 303 einer siebten Ausführungsform der erfindungsgemäßen NMR-Apparatur im Betriebszustand mit demontierter Schleusenkammer, bei der die probenkopfseitigen thermischen Kontaktelemente 302 über einen externen umlaufenden Kühlfluidstrom von einem Kryokühler 2 des NMR-Probenkopfes gekühlt werden.

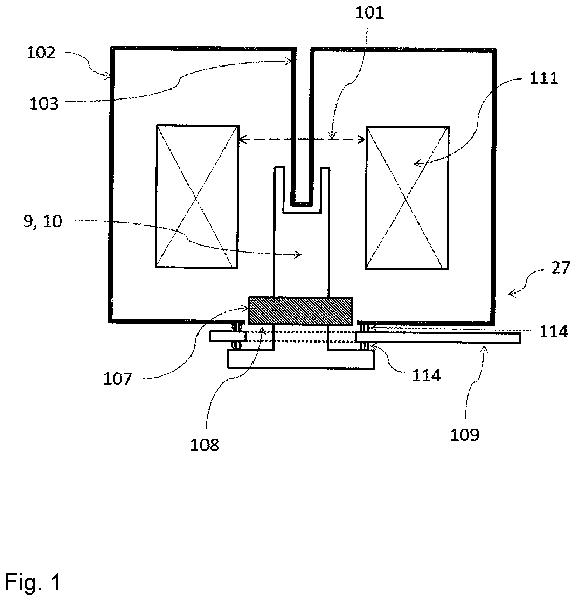

Figur 1 veranschaulicht schematisch eine erste Ausführungsform der erfindungsgemäßen NMR-Apparatur im Betriebszustand mit demontierter Schleusenkammer.

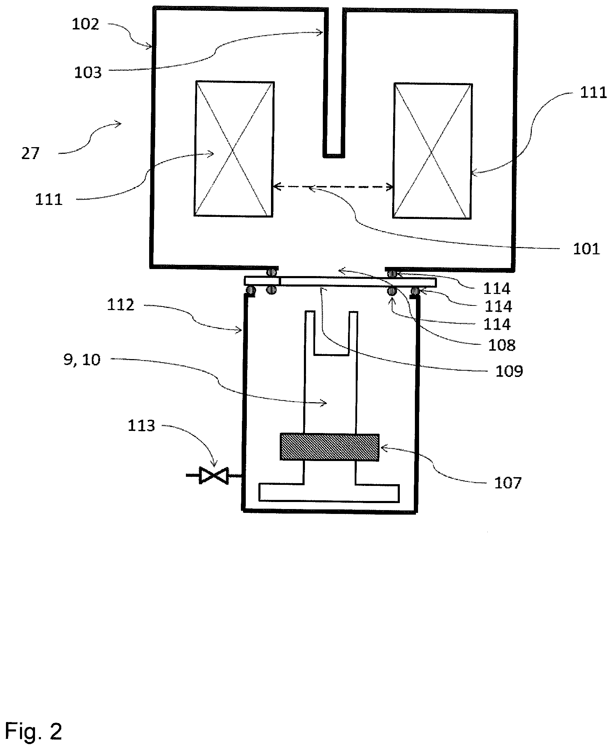

In Figur 2 ist dieselbe Ausführungsform wie in Fig. 1 dargestellt, bei der zum Einführen des NMR Probenkopfes 11 in den Kaltbereich des Kryostaten eine Schleusenkammer 112 über ein Schleusenventil 109 von unten her an den Vakuumbehälter 102 des Kryostaten angekoppelt ist.

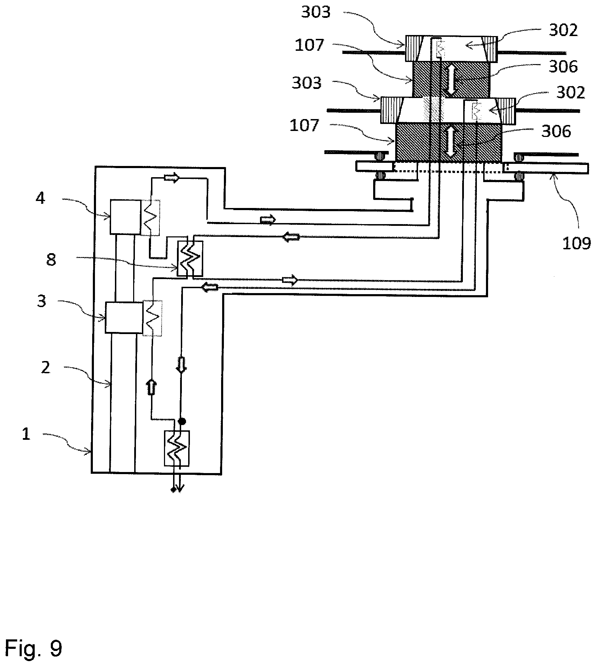

Figuren 1 und 2 illustrieren zwei Zustände der erfindungsgemäßen NMR-Apparatur, wie sie beim Verfahren gemäß Anspruch 15 durchlaufen werden. Figur 1 korrespondiert dabei mit dem Zustand vor dem ersten (a) bzw. nach dem letzten (k) beschriebenen Schritt, Figur 2 mit dem Zustand zwischen den Schritten (e) und (f). Im Betriebszustand (Figur 1) ist der NMR Probenkopf 11 über elektrische und gegebenenfalls Fluid-Leitungen (Figur 9) mit anderen Teilen der NMR-Apparatur verbunden. Diese werden in einem ersten Schritt (a) abgekoppelt. Das ermöglicht dann das vakuumdichte Anbringen der Schleusenkammer 112 an den Vakuumbehälter 102 des Kryostaten mit Hilfe der Dichtungsringe 114. Nachdem die Schleusenkammer 112 durch das Abpumpventil 113 evakuiert worden ist, kann das Schleusenventil 109 geöffnet werden, und der NMR-Probenkopf 11 wird mittels einer mechanischen Führung entweder von einer internen Struktur (z.B. elektrisch betriebener Lift) oder von einer durch die Schleusenkammer 112 geführten Achse aus der Betriebsposition in die Ausbauposition gebracht. In der Ausbauposition liegt der NMR-Probenkopf 11 vollständig unterhalb der Ebene des Schleusenventils 109, so dass dieses geschlossen werden kann. Damit ist der Zustand in Figur 2 erreicht. Das Aufwärmen des NMR-Probenkopfes 11 von seiner Betriebstemperatur im Magneten auf annähernd Raumtemperatur erfolgt bevorzugt in der Schleusenkammer 112, da sich ansonsten Eis und/ oder Kondenswasser auf dem Kopf niederschlägt, was diesen beschädigen kann. Zudem führen zu schnelle Veränderungen der Temperatur auch zu großen inneren mechanischen Spannungen, was ebenfalls zur Beschädigung des Kopfes führen kann.

Das Aufwärmen erfolgt hauptsächlich durch Wärmestrahlung im evakuierten Zustand der Schleusenkammer 112. Zudem kann eine kleine Menge (∼ 1 mbar) Heliumgas in die Schleusenkammer geleitet werden, um den NMR-Probenkopf 11 thermisch konvektiv schwach an die Schleusenkammer zu koppeln. Alternativ dazu ist auch eine elektrische Heizstruktur auf dem NMR-Probenkopf 11 denkbar, mit der sich der Kopf kontrolliert und schonend aufwärmen lässt. Nach dem Aufwärmen auf Raumtemperatur wird die Schleusenkammer 112 geflutet. Dann wird die Schleusenkammer 112 durch Lösen der vakuumdichten Verbindung (Dichtringe 114) mitsamt dem NMR-Probenkopf 11 demontiert. Der NMR-Probenkopf 11 kann dann aus der Schleusenkammer 112 entnommen werden, und ein zweiter NMR-Probenkopf 11 wird in die Schleusenkammer 112 eingebracht. Nach dem Evakuieren der Schleusenkammer 112 wird das Schleusenventil 109 geöffnet, und der NMR-Probenkopf 11 wird vorzugsweise so langsam in die supraleitende Magnetanordnung 27 eingeführt, dass sich der NMR-Probenkopf 11 durch Wärmestrahlung langsam aber kontinuierlich abkühlt, so dass der thermische Schock beim Ankoppeln an die Kältestufen des Kryostaten minimiert wird.

Nach dem mechanischen Ankoppeln des NMR-Probenkopfes 11 an die supraleitende Magnetanordnung 27, und der Fixierung des NMR-Probenkopfes 11 in seiner Betriebsposition ist auch die Vakuumdichtheit der Verbindung des NMR Probenkopfes 11 mit dem Vakuumbehälter 102 des Kryostaten gegenüber Atmosphäre hergestellt, und die Schleusenkammer 112 kann über das Abpumpventil 113 geflutet und entfernt werden.

Zuletzt werden die elektrischen und gegebenenfalls Fluid-Verbindungen des NMR-Probenkopfes 11 zur NMR-Apparatur wieder hergestellt. Damit ist das Ein- und Ausbauverfahren des NMR-Probenkopfes 11 abgeschlossen.

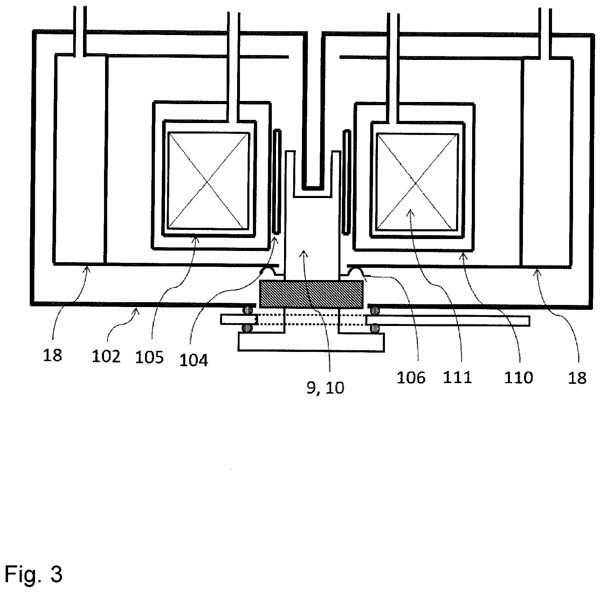

In den Figuren 3 bis 8 wird in der Kaltbohrung 101 des supraleitenden Magnetspulensystems 111 das Shimsystem 104 gezeigt. Dieses kann passive Elemente (in der Regel Eisenshims) umfassen, die das Feld durch ihre magnetische Suszeptibilität beeinflussen, und deren geometrische Verteilung zur Korrektur von Feldinhomogenitäten genutzt wird. Diese passiven Shims sind auf einer mechanischen Trägerstruktur angebracht. Vorteilhaft dafür ist z.B. die Nutzung eines metallischen Rohres, das einen Teil eines Strahlungsschildes 21 oder 110 bilden kann und mit diesem in thermischem und mechanischem Kontakt steht. Das Shimsystem 104 kann aber auch aus aktiven Komponenten aufgebaut sein. Dann umfasst es stromdurchflossene Leiterschleifen, typischerweise aus einem guten elektrischen Leiter wie Kupfer oder sogar aus Supraleitermaterial. In beiden Fällen ist eine Kopplung an eine Kältestufe des Kryostaten von Vorteil, beim Supraleiter sogar zwingend erforderlich. Auch hier bietet sich die Montage auf ein Trägerrohr an, das beispielsweise mit einem Strahlungsschild 21 oder 110 in thermischer Verbindung steht.

Figur 3 zeigt eine Ausführungsform der supraleitenden Magnetanordnung 27 mit Heliumbehälter 105, Strahlungsschild 110 und Stickstoffbehälter 18. Der Stickstoffbehälter 18 ist thermisch an den NMR-Probenkopf 11 mit den gekühlten Probenkopfkomponenten 9, 10 gekoppelt. Das erlaubt eine Kühlung der gekühlten Probenkopfkomponenten 9, 10 durch den Stickstoffbehälter 18. Der Strahlungsschild 110 ist durch Restenthalpie des vom Heliumbehälter 105 abströmenden tiefkalten Heliumgases gekühlt, und befindet sich auf einer Gleichgewichtstemperatur, die zwischen der des Heliumbehälters 105 und der des Stickstoffbehälters 18 liegt.

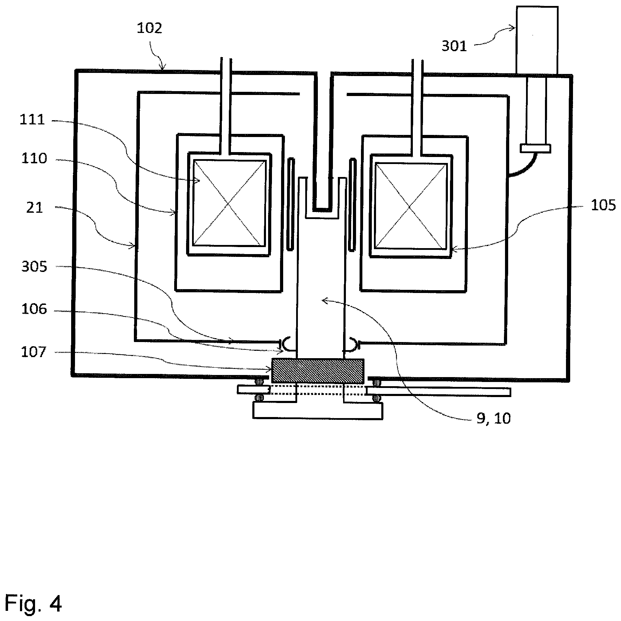

Figur 4 zeigt eine Ausführungsform mit einem einstufigen Kryokühler 301 anstelle eines Stickstoffbehälters 18. Dieser kühlt einen weiteren Strahlungsschild 21, der den Strahlungsschild 110 umgibt. Der Strahlungsschild 21 liegt hierbei typischerweise auf einer Temperatur zwischen 30 und 90 Kelvin. Der Strahlungsschild 110 ist wie bei der vorhergehenden Ausführungsform durch Restenthalpie des vom Heliumbehälter 105 abströmenden tiefkalten Heliumgases gekühlt, und befindet sich auf einer Gleichgewichtstemperatur, die zwischen der des Heliumbehälters 105 und der des weiteren Strahlungsschildes 21 liegt. Eine Kopplung des NMR-Probenkopfes 11 mit der Kältestufe des Kryostaten, welche durch die erste Stufe 307 des einstufigen Kryokühlers 301 gekühlt wird, vermittelt eine Kühlung der gekühlten Probenkopfkomponenten 9, 10 durch diese Stufe 307. Die gekühlten Probenkopfkomponenten 9, 10 können auf diese Art vorteilhaft im Temperaturintervall zwischen 30 und 90 Kelvin betrieben werden. Würde die Temperatur deutlich über dieses Niveau gebracht, wären massive Performanceverluste in den NMR Messungen die Folge. Würden die gekühlten Probenkopfkomponenten andererseits mit dem Heliumbehälter 105 oder dem kälteren Strahlungsschild 110 auf eine deutlich tiefere Temperatur gekoppelt, so könnte die in den gekühlten Probenkopfkomponenten 9, 10 dissipierte Leistung nicht mehr durch den Kryokühler 301 abgeführt werden, sondern müsste durch das Verdampfen von flüssigem Helium aus dem Heliumbehälter 105 gekühlt werden, was zu einem massiven Anstieg der Heliumverbrauchswerte führen würde. Die gezeigte Variante kombiniert daher niedrige Heliumverbrauchswerte mit guter NMR-Performance.

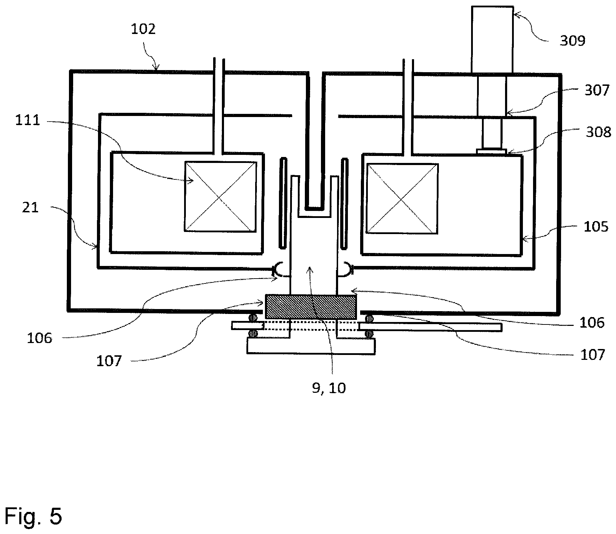

Figur 5 zeigt eine Ausführungsform mit einem zweistufigen Kryokühler 309. Die erste Stufe 307 ist dabei wie in der vorhergehenden Ausführungsform (Figur 4) an den Strahlungsschild 21 und über diesen an die gekühlten Probenkopfkomponenten 9, 10 gekoppelt. Dieses durch die erste Stufe 307 des Kryokühlers gekühlte Teilsystem funktioniert bezüglich der Wärmeflüsse wie die in Figur 4 beschriebene Ausführungsform. Zusätzlich hat der Kryokühler 309 aber noch eine zweite Stufe 308, die Kühlleistung bei einer Temperatur unter der Siedetemperatur von Helium zur Verfügung stellt. Mit dieser Kühlleistung wird das im Heliumbehälter 105 verdampfende Helium noch im Heliumbehälter 105 direkt wieder verflüssigt, ohne den Heliumbehälter 105 zu verlassen. Ein durch Restenthalpie von aus dem Heliumbehälter 105 abströmendem Heliumgases gekühlter Strahlungsschild 110, wie in Figur 4, entfällt in dieser Variante. Diese Ausführungsform verbindet die gute NMR-Performance der Ausführungsform gemäß Figur 4 mit einer praktisch unbegrenzten Heliumhaltezeit.

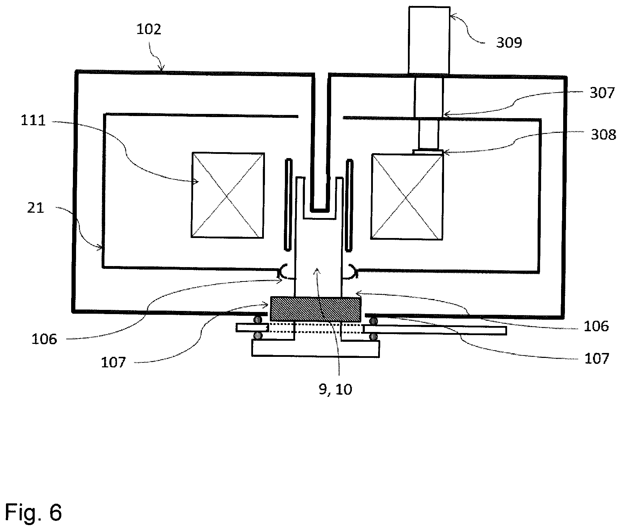

Figur 6 zeigt eine Weiterentwicklung der Anordnung von Figur 5. Das thermische Design ist identisch, aber der Magnet ist nun nicht mehr in einem Heliumbehälter 105 untergebracht, sondern wird durch Festkörperstrukturen (z.B. aus Kupfer) thermisch mit der zweiten Stufe 308 des Kryokühlers 309 gekoppelt. Da sich hier weder Helium noch Stickstoff im System befinden, handelt es sich um eine kryogenfreie Ausführungsform. Die Verwendung eines zweistufigen Kryokühlers erlaubt dank der typischerweise sehr tiefen Basistemperatur im Bereich einstelliger Kelvinwerte insbesondere die Verwendung von kostengünstigen niobbasierten Tieftemperatursupraleitern oder auch MgB2.

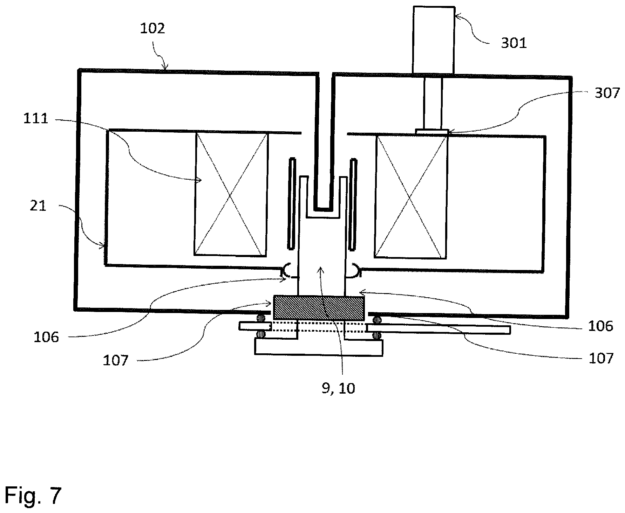

Figur 7 zeigt eine Ausführungsform, die auf einem einstufigen Kryokühler 301 basiert. Die erste (und einzige) Stufe 307 des Kryokühlers 301 ist dabei sowohl mit dem Strahlungsschild 21 und über diesen mit den gekühlten Probenkopfkomponenten 9, 10 gekoppelt als auch mit einem kryogenfreien supraleitenden Magnetspulensystem 111. Die für einstufige Kryokühler typischerweise erreichbaren Betriebstemperaturen bei einer für eine solche Ausführungsform typischen Gesamtwärmelast im Bereich von 5 bis 20 Watt liegen bei typischerweise 40 Kelvin oder darüber, was die supraleitende Magnetanordnung 27 auf hochtemperatursupraleiterbasierte supraleitende Magnetspulensysteme 111 einschränkt.

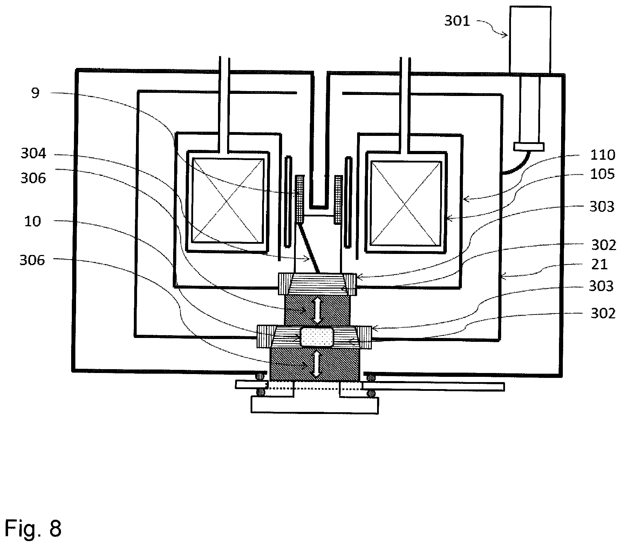

Figur 8 zeigt eine Ausführungsform eines lösbaren thermischen Kontaktes 106 zwischen NMR-Probenkopf 11 mit den gekühlten Probenkopfkomponenten 9, 10 einerseits und den Strahlungsschilden 21, 110 der in Figur 4 beschriebenen Ausführungsform. Die thermische Verbindung kommt über ein probenkopfseitiges thermisches Kontaktelement 302 und über ein thermisches Kontaktelement 303 der Kältestufe des Kryostaten zustande, welche typischerweise als goldbeschichteter Konus und Gegenkonus ausgeführt sind. Jeder Konus ist dabei von einem Federelement 306 gestützt, der die nötige Anpresskraft auf den Gegenkonus garantiert. Diese Kraft wird durch die spezielle Geometrie des Konus noch deutlich verstärkt, da die axiale Kraft, die das Federelement 306 liefert, eine um bis zu einer Größenordnung höhere Normalkraft an der Kontaktfläche bewirkt, welche letztlich für die thermische Kopplung zwischen dem Konus und dem Gegenkonus sorgt. Die gekühlte Probenkopfkomponente 9 umfasst in dieser Ausführungsform eine HF-Spule, welche an den Strahlungsschild 110 gekoppelt ist, während die gekühlte Probenkopfkomponente 10, beispielsweise eine elektronische Verstärkerkomponente, auf der höheren Temperatur des wärmeren Strahlungsschildes 21 betrieben wird.

Figur 9 schließlich zeigt eine Ausführungsform der erfindungsgemäßen NMR-Apparatur, bei welcher Kältestufen des Kryostaten einer supraleitenden Magnetanordnung 27 und gekühlte Probenkopfkomponenten 9, 10 eines NMR-Probenkopfs 11 gemeinsam von einem Kryokühler 2 des NMR-Probenkopfes 11 gekühlt werden. Dabei durchläuft ein vom Kompressor dieses Kryokühlers 2 getriebener Kühlfluidstrom nacheinander einen ersten Gegenstromwärmetauscher, einen Wärmetauscher auf der ersten Stufe 3 des Kryokühlers 2, einen Gegenstromwärmetauscher 8 und einen Wärmetauscher auf der zweiten Stufe 4 des Kryokühlers 2, bis das Kühlfluid auf eine Temperatur im Bereich von typischerweise 10 Kelvin heruntergekühlt ist. Das Kühlfluid wird dann durch eine wärmeisolierte Leitung zum NMR-Probenkopf 11 geführt und wird dort über einen Wärmetauscher an das kühlere probenkopfseitige thermische Kontaktelement 302 gekoppelt, und fließt dann zurück in das wärmeisolierte Gehäuse 1 des Kryokühlers 2. Nach Durchlaufen des Gegenstromwärmetauschers 8 fließt das Kühlfluid dann zum Wärmetauscher am wärmeren probenkopfseitigen Kontaktelement 302, und von dort aus zurück in das wärmeisolierte Gehäuse 1 und schließlich über den ersten Gegenstromwärmetauscher zurück zum Kompressor.

Die gekühlten Probenkopfkomponenten 9, 10 werden mit den probenkopfseitigen thermischen Kontaktelementen 302 wärmeleitend verbunden, beispielsweise über eine wärmeleitende mechanische Struktur 304.

In dieser Ausführungsform mit thermischer Anbindung der probenkopfseitigen thermische Kontaktelemente 302 an einen durch einen Kryokühler 2 des NMR-Probenkopfs11 gekühlten Kühlkreislauf ist der Wärmefluss gegenüber der in Figur 4 beschriebenen Ausführungsform umgekehrt. Hier wird die supraleitende Magnetanordnung 27 vom Kryokühler 2 des NMR-Probenkopfes 11 mitgekühlt, in Figur 4 dagegen wird der NMR-Probenkopf 11 mit seinen gekühlten Probenkopfkomponenten 9, 10 vom Kryokühler 301 des Kryostaten der supraleitenden Magnetanordnung 27 mitgekühlt.

Auch eine Anordnung mit einem lediglich einstufigen Kryokühler 2 des Probenkopfes ist denkbar. Dann entfallen in der Ausführungsform gemäß Figur 9 der Gegenstromwärmetauscher 8 und die zweite Stufe 4 des Krokühlers 2. Die Folge sind höhere Temperaturen an den gekühlten Probenkopfkomponenten 9, 10, was zu einer reduzierten NMR-Performance führt, die aber für manche Anwendungen ausreichen kann.

Wenn die gekühlten Probenkopfkomponenten 9, 10 über einen Kühlfluidstrom gekühlt werden, und wenn die Kältestufen des Kryostaten durch einen Kryokühler 301 des Kryostaten oder durch Verdampfung von kryogenen Flüssigkeiten gekühlt werden, dann kann auf eine thermische Ankopplung der Kältestufen des Kryostaten an die gekühlten Probenkopfkomponenten 9, 10 verzichtet werden. Die thermischen Kontaktelemente 302, 303 entfallen dann.

### Bezugszeichenliste:

- 1: wärmeisoliertes Gehäuse
- 2: Kryokühler des NMR-Probenkopfes
- 3: erste Stufe des Kryokühlers 2
- 4: zweite Stufe des Kryokühlers 2
- 8: Gegenstromtauscher
- 9: gekühlte Probenkopfkomponente
- 10: gekühlte Probenkopfkomponente
- 11: NMR-Probenkopf
- 18: Stickstoffbehälter
- 21: Strahlungsschild
- 27: supraleitende Magnetanordnung
- 101: Kaltbohrung des supraleitenden Magnetspulensystems
- 102: Vakuumbehälter des Kryostaten
- 103: Raumtemperaturzugang
- 104: Shimsystem
- 105: Heliumbehälter
- 106: lösbarer thermischer Kontakt
- 107: thermische Isolation
- 108: Öffnung im Vakuumbehälter
- 109: Schleusenventil
- 110: Strahlungsschild
- 111: supraleitendes Magnetspulensystem
- 112: Schleusenkammer
- 113: Abpumpventil
- 114: Dichtungsring
- 301: einstufiger Kryokühler des Kryostaten
- 302: probenkopfseitiges thermisches Kontaktelement
- 303: thermisches Kontaktelement der Kältestufe des Kryostaten
- 304: wärmeleitende mechanische Struktur
- 306: Federelement
- 307: erste Stufe des Kryokühlers
- 308: zweite Stufe des Kryokühlers
- 309: zweistufiger Kryokühler des Kryostaten

### Referenzliste:

Für die Beurteilung der Patentfähigkeit in Betracht gezogene Druckschriften
[1] US 2012/0319690 A1
[2] US 2012/0242335 A1
[3] US 2007/0107445 A1
[4] US 2005/0202976 A1
[5] US 2006/0130493 A1
[6] US 2013/063148 A1

## Patentansprüche

1. NMR-Apparatur mit einer supraleitenden Magnetanordnung (27) mit einem Kryostaten, welcher einen Vakuumbehälter (102) und eine auf einer Betriebstemperatur < 100 K betreibbare Kältestufe umfasst, und mit einem supraleitenden Magnetspulensystem (111) mit einer Kaltbohrung (101), in die ein Raumtemperaturzugang (103) des Kryostaten eingreift, wobei die NMR-Apparatur einen NMR-Probenkopf (11) mit auf eine Betriebstemperatur < 100 K zu kühlenden Probenkopfkomponenten (9, 10) umfasst,
**dadurch gekennzeichnet,**
**dass** die zu kühlenden Probenkopfkomponenten (9, 10) mindestens zum Teil in einem Bereich zwischen der Kaltbohrung (101) des supraleitenden Magnetspulensystems (111) und dem Raumtemperaturzugang (103) des Kryostaten in die Kaltbohrung (101) radial innerhalb der Kaltbohrung (101), aber außerhalb des Raumtemperaturzugangs (103) des Kryostaten angeordnet sind,
**dass** ein Schleusenventil (109) vorgesehen ist, und dass der Vakuumbehälter (102) des Kryostaten eine mit dem Schleusenventil (109) verschließbare Öffnung (108) sowie eine Schleusenkammer (112) im unmittelbaren Anschluss an die Öffnung (108) oder eine Vorrichtung zur vakuumdichten Anbringung einer Schleusenkammer (112) im unmittelbaren Anschluss an die Öffnung (108) aufweist,
und **dass** die Öffnung (108) und das Schleusenventil (109) so dimensioniert und derart angeordnet sind, dass die zu kühlenden Probenkopfkomponenten (9, 10) durch sie hindurch ein- und/oder ausgebaut werden können.

2. NMR-Apparatur nach Anspruch 1, **dadurch gekennzeichnet, dass** die in einem Bereich zwischen der Kaltbohrung (101) des supraleitenden Magnetspulensystems (111) und dem Raumtemperaturzugang (103) des Kryostaten in der Kaltbohrung (101) angeordneten zu kühlenden Probenkopfkomponenten (9, 10) eine HF-Spule umfassen.

3. NMR-Apparatur nach Anspruch 1 oder 2, **dadurch gekennzeichnet, dass** ein mechanisch lösbarer thermischer Kontakt (106) zwischen den zu kühlenden Probenkopfkomponenten (9, 10) und einer Kältestufe des Kryostaten vorhanden ist.

4. NMR-Apparatur nach Anspruch 3, **dadurch gekennzeichnet, dass** der Kryostat eine Kältestufe mit einem Stickstoffbehälter (18) umfasst, und dass die zu kühlenden Probenkopfkomponenten (9, 10) über den lösbaren thermischen Kontakt (106) an die den Stickstoffbehälter (18) umfassende Kältestufe des Kryostaten gekoppelt sind.

5. NMR-Apparatur nach Anspruch 3, **dadurch gekennzeichnet, dass** der Kryostat eine Kältestufe mit einem durch einen einstufigen Kryokühler (301) gekühlten Strahlungsschild (21) umfasst, und dass die zu kühlenden Probenkopfkomponenten (9, 10) über den lösbaren thermischen Kontakt (106) an die den durch den einstufigen Kryokühler (301) gekühlten Strahlungsschild (21) umfassende Kältestufe des Kryostaten gekoppelt sind.

6. NMR-Apparatur nach Anspruch 3, **dadurch gekennzeichnet, dass** der Kryostat eine Kältestufe mit einem durch die erste Stufe (307) eines zweistufigen Kryokühlers (309) gekühlten Strahlungsschild (21) umfasst, und dass die zu kühlenden Probenkopfkomponenten (9, 10) über den lösbaren thermischen Kontakt (106) an die den durch die erste Stufe (307) des zweistufigen Kryokühlers (309) gekühlten Strahlungsschild (21) umfassende Kältestufe des Kryostaten gekoppelt sind.

7. NMR-Apparatur nach Anspruch 3, **dadurch gekennzeichnet, dass** der Kryostat eine Kältestufe mit einem durch einen einstufigen Kryokühler (301) gekühlten supraleitenden Magnetspulensystem (111) umfasst, und dass die zu kühlenden Probenkopfkomponenten (9, 10) über den lösbaren thermischen Kontakt (106) an die das durch den einstufigen Kryokühler (301) gekühlte supraleitende Magnetspulensystem (111) umfassende Kältestufe des Kryostaten gekoppelt sind.

8. NMR-Apparatur nach Anspruch 3, **dadurch gekennzeichnet, dass** der mechanisch lösbare thermische Kontakt (106) thermische Kontaktelemente (302, 303) umfasst, die auf den beiden Seiten des mechanisch lösbaren thermischen Kontaktes (106) als Konus und als dazu formschlüssiger Gegenkonus ausgebildet sind, wobei Konus und Gegenkonus aus einem wärmeleitenden Material mit einer Wärmeleitfähigkeit bei der Betriebstemperatur der Anordnung von mehr als 20 W / (K * m), insbesondere aus Kupfer, gefertigt sind, wobei Konus und Gegenkonus mit einem Edelmetall, insbesondere mit Gold, beschichtet sind, und wobei im Betriebszustand Konus und Gegenkonus durch ein Federelement (306) mit einer Kraft von mindestens 20 N gegeneinander gedrückt werden.

9. NMR-Apparatur nach Anspruch 1 oder 2, **dadurch gekennzeichnet, dass** die zu kühlenden Probenkopfkomponenten (9,10) über einen externen Kühlkreislauf von außerhalb des Kryostaten kühlbar sind.

10. NMR-Apparatur nach einem der vorhergehenden Ansprüche, **dadurch gekennzeichnet, dass** die zu kühlenden Probenkopfkomponenten (9,10) normalleitende und/oder supraleitende Bauteile umfassen.

11. NMR-Apparatur nach den Ansprüchen 3 und 9, **dadurch gekennzeichnet, dass** der mechanisch lösbare thermische Kontakt (106) thermische Kontaktelemente (302, 303) umfasst, wobei das probenkopfseitige thermische Kontaktelement (302) im Betriebszustand der Anordnung kälter ist als das thermische Kontaktelement (303) der Kältestufe des Kryostaten.

12. NMR-Apparatur nach einem der vorhergehenden Ansprüche, **dadurch gekennzeichnet, dass** der NMR-Probenkopf (11) so gestaltet ist, dass ein Teil des NMR-Probenkopfes (11) das geöffnete Schleusenventil (109) in der Öffnung (108) im Vakuumbehälter (102) des Kryostaten luftdichtabschließt, so dass die Schleusenkammer (112) im Betriebszustand demontierbar ist.

13. NMR-Apparatur nach einem der vorhergehenden Ansprüche, **dadurch gekennzeichnet, dass** das supraleitende Magnetspulensystem (111) LTS- und/oder HTS-Elemente umfasst.

14. NMR-Apparatur nach einem der vorhergehenden Ansprüche, **dadurch gekennzeichnet, dass** die supraleitende Magnetanordnung (27) ein aktives Shimsystem (104) mit Shimspulen oder ein passives Shimsystem (104) mit einem oder mehreren ferromagnetischen Feldformelementen innerhalb des Kryostaten zur Homogenisierung des erzeugten Magnetfelds umfasst, und dass das Shimsystem (104) zwischen der Kaltbohrung (101) des supraleitenden Magnetspulensystems (111) und den zu kühlenden Probenkopfkomponenten (9, 10) mit thermischer Anbindung an eine Kältestufe des Kryostaten oder an einen externen Kühlkreislauf angeordnet ist.

15. Verfahren zum Aus- und Einbau der zu kühlenden Probenkopfkomponenten (9, 10) in den Vakuumbehälter (102) eines Kryostaten einer supraleitenden Magnetanordnung (27) einer NMR-Apparatur nach Anspruch 12, **gekennzeichnet durch** folgende Schritte:
(a) Abkoppelung von Anschlussleitungen des NMR-Probenkopfs (11) zu anderen Teilen der NMR-Apparatur
(b) Anbringung einer Schleusenkammer (112) am Schleusenventil (109)
(c) Evakuieren der Schleusenkammer (112)
(d) Verschiebung der auszubauenden Probenkopfkomponenten (9, 10) aus dem Vakuumbehälter (102) des Kryostaten in die Schleusenkammer (112)
(e) Schließen des Schleusenventils (109)
(f) Fluten und Öffnen der Schleusenkammer (112) und Entnahme der ausgebauten Probenkopfkomponenten (9, 10)
(g) Einführen der einzubauenden Probenkopfkomponenten (9, 10) in die Schleusenkammer (112) und Verschließen sowie Evakuieren der Schleusenkammer (112)
(h) Öffnen des Schleusenventils (109)
(i) Verschieben der einzubauenden Probenkopfkomponenten (9, 10) aus der Schleusenkammer (109) in den Vakuumbehälter (102) des Kryostaten
(j) Fluten und Entfernen der Schleusenkammer (112)
(k) Ankoppelung der Anschlüsse eines externen Kühlkreislaufs an den NMR-Probenkopf (11).

## Claims

1. An NMR apparatus comprising a superconducting magnet assembly (27) that comprises a cryostat which has a vacuum tank (102) and a refrigeration stage that can be operated at an operating temperature of < 100 K, and that comprises a superconducting magnet coil system (111) that comprises a cold bore (101) into which a room temperature access (103) of the cryostat engages, the NMR apparatus comprising an NMR probe (11) comprising probe components (9, 10) to be cooled to an operating temperature of < 100 K,
**characterized**
**in that** the probe components (9, 10) to be cooled are arranged, at least in part, in a region between the cold bore (101) of the superconducting magnet coil system (111) and the room temperature access (103) of the cryostat into the cold bore (101), radially inside the cold bore (101) but outside the room temperature access (103) of the cryostat,
**in that** a lock valve (109) is provided, and
**in that** the vacuum tank (102) of the cryostat comprises an opening (108) that can be closed by means of the lock valve (109), and a lock chamber (112) which is directly connected to the opening (108) or a device for attaching a lock chamber (112) to the opening (108) in a vacuum-tight manner such that said lock chamber and opening are directly connected, and in that the opening (108) and the lock valve (109) are of such a size and are arranged such that the probe components (9, 10) to be cooled can be installed and/or removed through said opening and lock valve.

2. The NMR apparatus according to claim 1, **characterized in that** the probe components (9, 10) to be cooled, which are arranged in a region between the cold bore (101) of the superconducting magnet coil system (111) and the room temperature access (103) of the cryostat into the cold bore (101), include an HF coil.

3. The NMR apparatus according to either claim 1 or claim 2, **characterized in that** a mechanically releasable thermal contact (106) is provided between the probe components (9, 10) to be cooled and a refrigeration stage of the cryostat.

4. The NMR apparatus according to claim 3, **characterized in that** the cryostat comprises a refrigeration stage comprising a nitrogen tank (18), and **in that** the probe components (9, 10) to be cooled are coupled by means of the releasable thermal contact (106) to the refrigeration stage of the cryostat that comprises the nitrogen tank (18).

5. The NMR apparatus according to claim 3, **characterized in that** the cryostat comprises a refrigeration stage comprising a radiation shield (21) which is cooled by a single-stage cryocooler (301), and **in that** the probe components (9, 10) to be cooled are coupled by means of the releasable thermal contact (106) to the refrigeration stage of the cryostat that comprises the radiation shield (21) cooled by the single-stage cryocooler (301).

6. The NMR apparatus according to claim 3, **characterized in that** the cryostat comprises a refrigeration stage comprising a radiation shield (21) which is cooled by the first stage (307) of a two-stage cryocooler (309), and **in that** the probe components (9, 10) to be cooled are coupled by means of the releasable thermal contact (106) to the refrigeration stage of the cryostat that comprises the radiation shield (21) cooled by the first stage (307) of the two-stage cryocooler (309).

7. The NMR apparatus according to claim 3, **characterized in that** the cryostat comprises a refrigeration stage comprising a superconducting magnet coil system (111) which is cooled by a single-stage cryocooler (301), and **in that** the probe components (9, 10) to be cooled are coupled by means of the releasable thermal contact (106) to the refrigeration stage of the cryostat that comprises the superconducting magnet coil system (111) cooled by the single-stage cryocooler (301).

8. The NMR apparatus according to claim 3, **characterized in that** the mechanically releasable thermal contact (106) comprises thermal contact elements (302, 303) which are formed on either side of the mechanically releasable thermal contact (106) as a cone and an interlocking mating cone, the cone and mating cone being produced from a heat-conductive material having a heat conductivity at the operating temperature of the assembly of greater than 20 W / (K * m), in particular copper, the cone and mating cone being coated with a noble metal, in particular gold, and the cone and mating cone being pressed against one another in the operating state by a spring element (306) at a force of at least 20 N.

9. The NMR apparatus according to either claim 1 or claim 2, **characterized in that** the probe components (9, 10) to be cooled can be cooled from outside the cryostat by means of an external cooling circuit.

10. The NMR apparatus according to any of the preceding claims, **characterized in that** the probe components (9, 10) to be cooled include normally conducting and/or superconducting components.

11. The NMR apparatus according to claims 3 and 9, **characterized in that** the mechanically releasable thermal contact (106) comprises thermal contact elements (302, 303), the probe-side thermal contact element (302) being colder than the thermal contact element (303) of the refrigeration stage of the cryostat in the operating state of the assembly.

12. The NMR apparatus according to any of the preceding claims, **characterized in that** the NMR probe (11) is designed such that part of the NMR probe (11) closes the open lock valve (109) in the opening (108) in the vacuum tank (102) of the cryostat in an air-tight manner, and therefore the lock chamber (112) can be detached in the operating state.

13. The NMR apparatus according to any of the preceding claims, **characterized in that** the superconducting magnet coil system (111) comprises LTS elements and/or HTS elements.

14. The NMR apparatus according to any of the preceding claims, **characterized in that** the superconducting magnet assembly (27) has an active shim system (104) comprising shim coils, or a passive shim system (104) comprising one or more ferromagnetic field-shaping elements, inside the cryostat in order to homogenize the magnetic field generated, and **in that** the shim system (104) is arranged between the cold bore (101) of the superconducting magnet coil system (111) and the probe components (9, 10) to be cooled and **in that** the shim system (104) is thermally attached to a refrigeration stage of the cryostat or to an external cooling circuit.

15. A method for installing and removing the probe components (9, 10) to be cooled in/from the vacuum tank (102) of a cryostat of a superconducting magnet assembly (27) of an NMR apparatus according to claim 12, **characterized by** the following steps:
(a) decoupling connection lines of the NMR probe (11) to other parts of the NMR apparatus
(b) attaching a lock chamber (112) to the lock valve (109)
(c) evacuating the lock chamber (112)
(d) moving the probe components (9, 10) to be removed out of the vacuum tank (102) of the cryostat and into the lock chamber (112)
(e) closing the lock valve (109)
(f) flooding and opening the lock chamber (112), and taking out the removed probe components (9, 10)
(g) introducing the probe components (9, 10) to be installed into the lock chamber (112), and closing and evacuating the lock chamber (112)
(h) opening the lock valve (109)
(i) moving the probe components (9, 10) to be installed out of the lock chamber (109) and into the vacuum tank (102) of the cryostat
(j) flooding and removing the lock chamber (112)
(k) coupling the connections of an external cooling circuit to the NMR probe (11).

## Revendications

1. Appareil RMN comprenant un agencement magnétique supraconducteur (27) avec un cryostat, qui comprend un récipient sous vide (102) et un étage frigorifique pouvant fonctionner à une température de fonctionnement < 100 K, et comprenant un système de bobine magnétique supraconducteur (111) avec un perçage froid (101) dans lequel s'engage un accès à la température ambiante (103) du cryostat, l'appareil RMN comprenant une tête d'échantillonnage RMN (11) avec des composants de tête d'échantillonnage (9, 10) à refroidir une température de fonctionnement < 100 K,
**caractérisé en ce que**
les composants de tête d'échantillonnage (9, 10) sont disposés au moins en partie dans une région entre le perçage froid (101) du système de bobine magnétique supraconducteur (111) et l'accès à la température ambiante (103) du cryostat dans le perçage froid (101) radialement à l'intérieur du perçage froid (101), mais à l'extérieur de l'accès à la température ambiante (103) du cryostat,
une vanne de sas (109) est prévue, et le récipient sous vide (102) du cryostat présente une ouverture (108) pouvant être fermée avec la vanne de sas (109) ainsi qu'une chambre de sas (112) se raccordant directement à l'ouverture (108) ou présente un dispositif pour l'application étanche au vide d'une chambre de sas (112) se raccordant directement à l'ouverture (108),
l'ouverture (108) et la vanne de sas (109) étant dimensionnées et disposées de telle sorte que les composants de tête d'échantillonnage (9, 10) à refroidir puissent être introduits et/ou ressortis par le biais de celles-ci.

2. Appareil RMN selon la revendication 1, **caractérisé en ce que** les composants de tête d'échantillonnage (9, 10) à refroidir disposés dans le perçage froid (101) dans une région entre le perçage froid (101) du système de bobine magnétique supraconducteur (111) et l'accès à la température ambiante (103) du cryostat comprennent une bobine HF.

3. Appareil RMN selon la revendication 1 ou 2, **caractérisé en ce qu'**un contact thermique mécaniquement détachable (106) est prévu entre les composants de tête d'échantillonnage à refroidir (9, 10) et un étage frigorifique du cryostat.

4. Appareil RMN selon la revendication 3, **caractérisé en ce que** le cryostat comprend un étage frigorifique avec un récipient d'azote (18) et **en ce que** les composants de tête d'échantillonnage à refroidir (9, 10) sont accouplés par le biais du contact thermique détachable (106) à l'étage frigorifique du cryostat comprenant le récipient d'azote (18).

5. Appareil RMN selon la revendication 3, **caractérisé en ce que** le cryostat comprend un étage frigorifique avec un écran de protection contre les rayonnements (21) refroidi par un cryorefroidisseur (301) à un étage, et **en ce que** les composants de tête d'échantillonnage à refroidir (9, 10) sont accouplés par le biais du contact thermique détachable (106) à l'étage frigorifique du cryostat comprenant l'écran de protection contre les rayonnements (21) refroidi par le cryorefroidisseur à un étage (301).

6. Appareil RMN selon la revendication 3, **caractérisé en ce que** le cryostat comprend un étage frigorifique avec un écran de protection contre les rayonnements (21) refroidi par le premier étage (307) d'un cryorefroidisseur à deux étages (309), et **en ce que** les composants de tête d'échantillonnage à refroidir (9, 10) sont accouplés par le biais du contact thermique détachable (106) à l'étage frigorifique du cryostat comprenant l'écran de protection contre les rayonnements (21) refroidi par le premier étage (307) du cryorefroidisseur à deux étages (309).

7. Appareil RMN selon la revendication 3, **caractérisé en ce que** le cryostat comprend un étage frigorifique avec un système de bobine magnétique supraconducteur (111) refroidi par un cryorefroidisseur à un étage (301), et **en ce que** les composants de tête d'échantillonnage à refroidir (9, 10) sont accouplés par le biais du contact thermique détachable (106) à l'étage frigorifique du cryostat comprenant le système de bobine magnétique supraconducteur (111) refroidi par le cryorefroidisseur à un étage (301).

8. Appareil RMN selon la revendication 3, **caractérisé en ce que** le contact thermique détachable mécaniquement (106) comprend des éléments de contact thermique (302, 303) qui sont réalisés des deux côtés du contact thermique détachable mécaniquement (106) sous forme de cône et sous forme de cône conjugué à engagement géométrique avec celui-ci, le cône et le cône conjugué étant fabriqués en un matériau thermoconducteur ayant une conductibilité thermique à la température de fonctionnement de l'agencement de plus de 20 W/(K*m), en particulier en cuivre, le cône et le cône conjugué étant revêtus d'un métal précieux, en particulier d'or, et, à l'état de fonctionnement, le cône et le cône conjugué étant pressés l'un contre l'autre par un élément de ressort (306) avec une force d'au moins 20 N.

9. Appareil RMN selon la revendication 1 ou 2, **caractérisé en ce que** les composants de tête d'échantillonnage à refroidir (9, 10) peuvent être refroidis par le biais d'un circuit de refroidissement externe depuis l'extérieur du cryostat.

10. Appareil RMN selon l'une quelconque des revendications précédentes, **caractérisé en ce que** les composants de tête d'échantillonnage à refroidir (9, 10) comprennent des composants normalement conducteurs et/ou supraconducteurs.

11. Appareil RMN selon les revendications 3 et 9, **caractérisé en ce que** le contact thermique détachable mécaniquement (106) comprend des éléments de contact thermique (302, 303), l'élément de contact thermique du côté de la tête d'échantillonnage (302) étant plus froid dans l'état de fonctionnement de l'agencement que l'élément de contact thermique (303) de l'étage frigorifique du cryostat.

12. Appareil RMN selon l'une quelconque des revendications précédentes, **caractérisé en ce que** la tête d'échantillonnage RMN (11) est configurée de telle sorte qu'une partie de la tête d'échantillonnage RMN (11) ferme de manière étanche à l'air la vanne de sas ouverte (109) dans l'ouverture (108) dans le récipient sous vide (102) du cryostat de sorte que la chambre de sas (112) puisse être démontée dans l'état de fonctionnement.

13. Appareil RMN selon l'une quelconque des revendications précédentes, **caractérisé en ce que** le système de bobine magnétique supraconducteur (111) comprend des éléments LTS et/ou HTS.

14. Appareil RMN selon l'une quelconque des revendications précédentes, **caractérisé en ce que** l'agencement magnétique supraconducteur (27) comprend un système de shim actif (104) avec des bobines de shim ou un système de shim passif (104) avec un ou plusieurs éléments conformateurs de champ ferromagnétiques à l'intérieur du cryostat pour l'homogénéisation du champ magnétique produit, et **en ce que** le système de shim (104) est disposé entre le perçage froid (101) du système de bobine magnétique supraconducteur (111) et les composants de tête d'échantillonnage à refroidir (9, 10) avec liaison thermique à un étage frigorifique du cryostat ou à un circuit de refroidissement externe.

15. Procédé de démontage et d'installation des composants de tête d'échantillonnage à refroidir (9, 10) dans le récipient sous vide (102) d'un cryostat d'un agencement magnétique supraconducteur (27) d'un appareil RMN selon la revendication 12, **caractérisé par** les étapes suivantes :
(a) découplage de conduites de raccordement de la tête d'échantillonnage RMN (11) à d'autres parties de l'appareil RMN,
(b) montage d'une chambre de sas (112) sur la vanne de sas (109),
(c) évacuation de la chambre de sas (112),
(d) déplacement des composants de tête d'échantillonnage à démonter (9, 10) hors du récipient sous vide (102) du cryostat dans la chambre de sas (112),
(e) fermeture de la vanne de sas (109),
(f) remplissage et ouverture de la chambre de sas (112) et enlèvement des composants de tête d'échantillonnage démonté (9, 10),
(g) introduction des composants de tête d'échantillonnage à installer (9, 10) dans la chambre de sas (112) et fermeture ainsi qu'évacuation de la chambre de sas (112),
(h) ouverture de la vanne de sas (109),
(i) déplacement des composants de tête d'échantillonnage à installer (9, 10) hors de la chambre de sas (109) dans le récipient sous vide (102) du cryostat,
(j) remplissage et enlèvement de la chambre de sas (112),
(k) accouplement des raccords d'un circuit de refroidissement externe à la tête d'échantillonnage RMN (11).
